# EUROPÄISCHE PATENTANMELDUNG

(11) **EP 1 845 620 A2**
(43) Veröffentlichungstag der Anmeldung: **17.10.2007**
(21) Anmeldenummer: 07006181.7
(22) Anmeldetag: 26.03.2007
(51) Int. Cl.: H03K 17/0814

(54) **Integriertes Beschaltungsbauelement auf Halbleiterbasis zur Shaltenlastung, Spannungsbegrenzung bzw. Schwingungsdämpfung**

(30) Priorität: 13.04.2006 DE 102006017487
(71) Anmelder: Fraunhofer-Gesellschaft zur Förderung der angewandten Forschung e.V., 80686 München (DE)
(72) Erfinder: Berberich, Sven, 91080 Spardorf (DE); März, Martin, 90491 Nürnberg (DE)
(74) Vertreter: Stöckeler, Ferdinand

(57) **Zusammenfassung**

Integriertes Beschaltungsbauelement auf Halbleiterbasis zur Beschaltung eines elektrischen Netzwerkes zur Absorption von elektrischer Energie aus einem elektrischen Energiespeicher eines elektrischen Netzwerkes, mit zumindest zwei Anschlüssen (12,14) zum Anschluss an das zu beschaltende, elektrische Netzwerk, einer elektrischen Widerstandsstruktur (16) und einer Reaktanzstruktur (6), die zwischen die Anschlüsse (12,14) geschaltet sind.

## Beschreibung

Die vorliegende Erfindung bezieht sich auf die Beschaltung elektrischer Netzwerke zur Schaltentlastung, Spannungsbegrenzung bzw. Schwingungsdämpfung, insbesondere auf den Einsatz von monolithisch integrierten Beschaltungsbauelementen zu oben genannten Zwecken in der Leistungselektronik und Hochfrequenztechnik.

In elektronischen Schaltungen besteht bei jedem Schaltvorgang die Gefahr der Anregung parasitärer Oszillationen. Darunter versteht man Oszillationen in Schwingkreisen, die aus unerwünschten elektrischen Energiespeichern, d.h. parasitäre Induktivitäten und Kapazitäten, gebildet werden. Bei realen Bauelementen und Aufbautechniken sind diese parasitären Elemente grundsätzlich unvermeidbar. Beispiele dafür sind die Eigenkapazitäten von Halbleiterbauelementen, die Leitungsinduktivitäten elektrischer Verbindungen oder die Streuinduktivitäten und Wicklungskapazitäten von Transformatoren.

Die Anregung von parasitären Schwingkreisen erfolgt durch Flanken in den Strömen oder Spannungen einer Schaltung. Die resultierenden Oszillationen bilden eine Quelle für elektromagnetische Störungen, die zu Fehlfunktionen in elektronischen Schaltungen führen können, und als energiereiche schmalbandige Störer die Einhaltung der einschlägigen EMV-Normen erheblich erschweren. Um die Amplitude parasitärer Oszillationen zu reduzieren, ist entweder eine Reduzierung der Steilheit der anregenden Strom- oder Spannungsflanken erforderlich und/oder eine Erhöhung der Dämpfung des ursächlichen parasitären Schwingkreises.

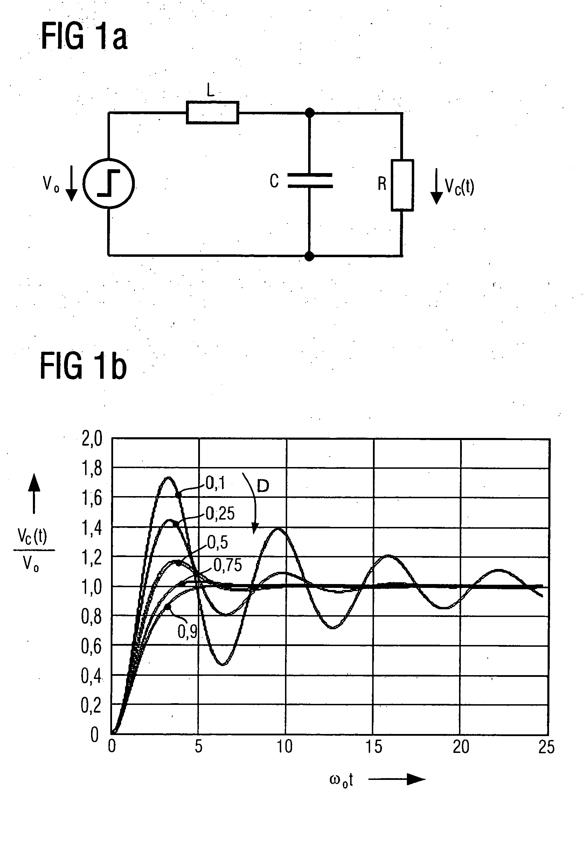

Fig. 1a zeigt beispielhaft einen Serienschwingkreis bestehend aus den Elementen L, C und einem Dämpfungswiderstand R. Fig. 1b beschreibt die Sprungantwort dieses Schwingkreises für unterschiedliche Dämpfungen. Für Werte der Dämpfung D im Bereich von 0.5 - 1 wird eine optimale Schaltflanke mit hoher Steilheit und zugleich keinem oder nur geringem Überschwingen erreicht.

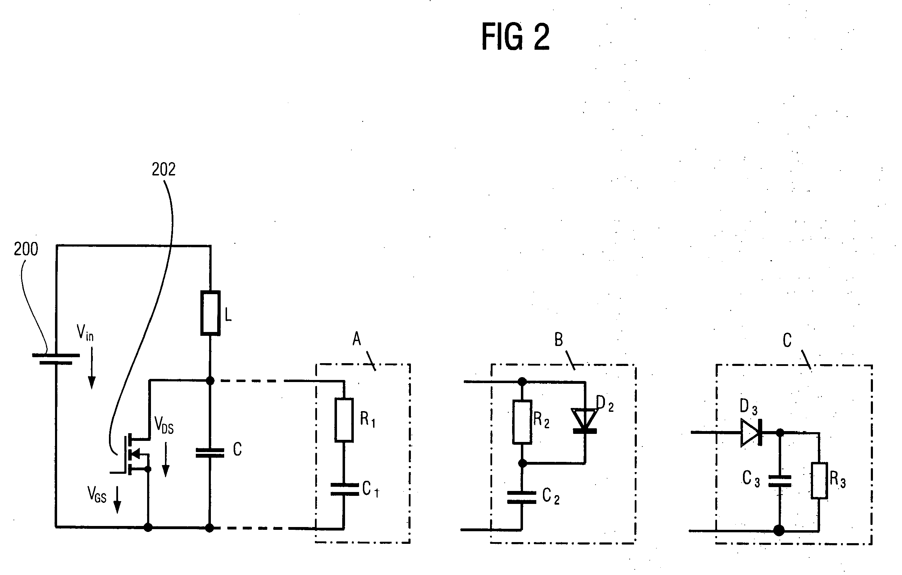

In realen Schaltungen ist es aus Verlustleistungsgründen im allgemeinen nicht vertretbar, den Dämpfungswiderstand unmittelbar parallel zu einer Komponente des parasitären Schwingkreises zu legen. Fig. 2 zeigt ein zu beschaltendes Netzwerk, das eine Spannungsquelle 200, die eine Spannung Vin liefert, einen MOSFET 202 und eine parasitäre Leitungsinduktivität L aufweist. Der MOSFET besitzt zusätzlich eine parasitäre Kapazität C, die als separates Element dargestellt ist. Sie stellt einen Energiespeicher dar, der mit einem Beschaltungsnetzwerk beschaltet werden soll, wobei beispielhafte Beschaltungstopologien in Fig. 2 durch die Netzwerke A, B und C gezeigt sind. Würde beispielsweise ein Dämpfungswiderstand parallel zu der parasitären Kapazität C, die durch die Drain-Source Kapazität des Leistungs-MOSFETs 202 (Fig. 2) gebildet ist, geschaltet werden, so würde bei ausgeschaltetem MOSFET permanent eine zum Quadrat der Drain-Source-Spannung V_{DS} proportionale Verlustleistung im Dämpfungswiderstand entstehen.

Für die gewünschte Dämpfungswirkung ist es im allgemeinen jedoch ausreichend, den Dämpfungswiderstand nur im Bereich der Schaltflanke wirksam werden zu lassen, und ihn stationär von der Schaltung abzukoppeln. Dies kann, wie in dem Dämpfungsnetzwerk A in Fig. 2 gezeigt, durch einen Koppelkondensator C₁ in Serie zu dem Widerstand R₁ erreicht werden. Dieser Koppelkondensator wird vorteilhaft so dimensioniert, dass seine Impedanz bei der zu dämpfenden Oszillationsfrequenz etwa dem 1/2- bis 1/2π-fachen des Werts des Dämpfungswiderstands R₁ entspricht.

Aber auch mit Koppelkondensator entsteht in dem Dämpfungswiderstand eine Verlustleistung, die in etwa der im parasitären Schwingkreis gespeicherten Energie multipliziert mit der Schaltfrequenz entspricht. Auf diesem Energieentzug beruht die Funktionsweise des Dämpfungswiderstands. Die entsprechende Verlustleistung ist daher unvermeidlich, sie kann in realen Anwendungen erhebliche Werte annehmen und eine effektive Kühlung des Widerstands erforderlich machen.

Ein weiterer entscheidender Punkt ist, dass der Widerstand seine Funktion nur erfüllen kann, wenn die Ankopplung an den zu dämpfenden Schwingkreis extrem niederinduktiv erfolgt. Anderenfalls koppelt die parasitäre Induktivität der Zuleitung den Dämpfungswiderstand gerade während der Schaltflanke von dem zu dämpfenden Schwingkreis ab und reduziert damit die Wirkung des Dämpfungsglieds erheblich.

Aus dem Beschriebenen resultieren Anforderungen an das Dämpfungsnetzwerk A, das aus dem Widerstand R₁ und dem Koppelkondensator C₁ besteht. Der Widerstandswert von R₁ sollte anpassbar an die charakteristische Impedanz Z₀ des zu dämpfenden parasitären LC-Schwingkreises (für optimales Dämpfungsverhalten) sein, und kann zwischen 0.5 Ω und 100 Ω liegen. Der Widerstand sollte effektiv kühlbar sein. Das Dämpfungsnetzwerk sollte einen niederinduktiven Aufbau und eine hohe Impulsbelastbarkeit aufweisen. Ferner sollte eine aufbautechnische Kompatibilität zu der zu bedämpfenden Schaltung (z.B. Leistungsmodul) für einfache Montage mit geringsten parasitären Anschlussinduktivitäten vorliegen.

Neben der reinen Bedämpfung eines parasitären Schwingkreises besteht eine weitere Möglichkeit zur Reduzierung der Amplitude parasitärer Oszillationen darin, die Steilheit der anregenden Strom- oder Spannungsflanke zu verringern. Dies ist beispielsweise mit einem so genannten dV/dt-Begrenzer wie dem Netzwerk B in Fig. 2 möglich. Das Netzwerk B umfasst eine Kapazität C₂ in Serie zu einem Widerstand R₂ und eine zu dem Widerstand R₂ parallel geschaltete Diode D₂. Ein solches Netzwerk wird sehr häufig auch zum Schutz von Bauelementen mit begrenzter dV/dt-Festigkeit, wie etwa Thyristoren, Triacs oder GTOs, eingesetzt.

Die Diode D₂ legt während der positiven Spannungsflanke (hier der Drain-Source-Spannung) den Kondensator C₂ direkt parallel zu dem Schaltungselement an dem die dV/dt-Begrenzung erfolgen soll. Der Ladevorgang von C₂ bewirkt unmittelbar die gewünschte Begrenzung der Steilheit der positiven Spannungsflanke. Das Rücksetzen der Spannung an C₂, d.h. das Entladen von C₂, erfolgt während der EIN-Phase des Schalters über den Entladewiderstand R₂, der zwischen 10 Ω und 500 Ω liegen kann. Die Diode D₂ und der Kondensator C₂ sind sehr hohen Spitzenbelastungen ausgesetzt. Während der Phase des Spannungsanstiegs kommutiert praktisch der gesamte Laststrom aus dem abschaltenden Bauelement (hier der MOSFET) auf diese beiden Elemente des dV/dt-Begrenzers.

Eine dritte, sehr häufig eingesetzte Beschaltung ist der Spannungsbegrenzer nach Fig. 2, Netzwerk C. Das Netzwerk C umfasst einen Widerstand R₃ parallel zu einer Kapazität C₃, wobei die Parallelschaltung von R₃ und C₃ seriell mit einer Diode D₃ verbunden ist.

Steigt die Spannung an dem zu schützenden Bauelement (hier der MOSFET 202) über die Spannung an dem Kondensator C₃, so klemmt die Diode D₃ die Spannung (V_{DS}) auf den Wert der Spannung an C₃. Im Gegensatz zu den Netzwerken A und B wird bei Netzwerk C die Kapazität von C₃ üblicherweise so groß gewählt, dass sich die Spannung an diesem Kondensator aufgrund der bei einem Schaltvorgang zu klemmenden Energie nur geringfügig ändert. Der Widerstand R₃ sorgt zwischen zwei Schaltvorgängen für die Umwandlung der pro Klemmvorgang zugeführten Energie in Wärme und kann zwischen 500 Ω und 10 kΩ liegen. Damit ergibt sich die mittlere Spannung an C₃ aus einem Gleichgewicht zwischen der zugeführten und der in R₃ in Wärme umgesetzten Energie.

Für eine hohe Wirksamkeit muss bei den Netzwerken B und C der Strompfad von den Anschlüssen des Netzwerks über die Diode und die Kapazität besonders niederinduktiv ausgeführt sein (während der Strompfad über den Widerstand speziell im Netzwerk C unkritisch ist).

Prinzipiell lassen sich Beschaltungsnetzwerke zur Schaltentlastung, Spannungsbegrenzung bzw. Schwingungsdämpfung, die als sogenannte Snubber-Netzwerke bezeichnet werden, in passive und aktive Netzwerke untergliedern. Passive Netzwerke bestehen aus passiven Bauelementen (Widerstände, Kapazitäten, Induktivitäten und Dioden), aktive Netzwerke enthalten zusätzlich einen oder mehrere aktive Schalter (z.B. MOS-Bauelemente). Ein Spezialfall sind Netzwerke mit nichtlinearen Bauelementen wie Z-Dioden, Varistoren, aktiv geklemmten Schaltern oder Strombegrenzern (Current-Limiter), die entsprechend ihrer Kennlinie Spannungen oder Ströme begrenzen.

Snubber-Netzwerke entnehmen Energie aus parasitären Reaktanzen einer elektronischen Schaltung. Je nachdem ob diese Energie in Wärme umgesetzt oder zurück in die Schaltung gespeist wird, unterscheidet man zwischen dissipativen und regenerativen Beschaltungsnetzwerken. Zur Dämpfung parasitärer Oszillationen werden praktisch ausschließlich dissipative Beschaltungsnetzwerke eingesetzt. Die Netzwerke A, B und C nach Fig. 2 arbeiten dissipativ.

Nach dem Stand der Technik werden Beschaltungsnetzwerke für die Leistungselektronik aus diskreten Bauelementen aufgebaut. Integrierte Lösungen für Anwendungen im Spannungsbereich bis zu einigen hundert Volt und für Spitzenströme bis zu einigen hundert Ampere sind bisher nicht bekannt. Lediglich zur Filterung von Signalleitungen sind integrierte Netzwerke z.B. auf der Basis von Dickschicht- oder LTCC-Technologien verfügbar. In diskret aufgebauten Beschaltungsnetzwerken kommen aufgrund der hohen Anforderungen an die Wechselstrombelastbarkeit überwiegend Folien- und Keramik-Kondensatoren zum Einsatz. Der elektrische Serienwiderstand eines Keramik-Kondensators ist für eine Verwendung des Kondensators als Snubber-Bauelement typischerweise nicht ausreichend. Selbst wenn man den Serienwiderstand erhöhen würde, wäre das resultierende Bauelement aufgrund seines hohen Wärmewiderstandes nur schwer kühlbar und somit als Subber-Bauelement schlecht geeignet. Besonders hohe Anforderungen an den Widerstand stellen RC-Dämpfungsglieder mit einem Aufbau gemäß dem Netzwerk A in Fig. 2. Hierfür werden niederinduktive Metallschichtwiderstände, im höheren Leistungsbereich auch Massewiderstände, eingesetzt. Bereits bei Verlustleistungen von wenigen Watt im Widerstand ist nach dem Stand der Technik aufgrund der räumlichen Ausdehnung der Einzelbauelemente und der Notwendigkeit zur Kühlung kein ausreichend niederinduktiver Aufbau des Netzwerks mehr realisierbar. Dies stellt angesichts der immer steileren Strom- und Spannungsflanken in modernen leistungselektronischen Systemen ein erhebliches Problem dar.

Die Anforderungen an eine extrem niedrige Eigeninduktivität der Beschaltungsnetzwerke lassen sich aufgrund der räumlichen Ausdehnung klassischer Bauelemente wie Kondensatoren, Leistungsdioden und Leistungswiderständen sowie aufgrund der erforderlichen Kühlung mit wachsenden Leistungen immer schwerer erfüllen.

Die Aufgabe der vorliegenden Erfindung besteht darin, eine Möglichkeit zu schaffen, durch die auch moderne leistungselektronische Systeme mit geringem Aufwand beschaltet werden können, um eine Schaltentlastung, eine Spannungsbegrenzung und/oder eine Schwingungsdämpfung zu erreichen.

Diese Aufgabe wird durch ein integriertes Beschaltungselement auf Halbleiterbasis gemäß Anspruch 1 und dessen Verwendung gemäß Anspruch 16 gelöst.

Die Erkenntnis der vorliegenden Erfindung besteht darin, dass durch die monolithische Integration eines Snubber-Netzwerkes in einen Chip ein extrem niederinduktiver Aufbau, eine besonders effektive Kühlbarkeit und eine montagetechnische Kompatibilität zu Leistungshalbleiterchips erreicht wird. Damit entstehen völlig neuartige integrierte Beschaltungsbauelemente. Es entsteht ein sehr kompaktes Bauelement, das alle Einzelelemente des jeweiligen Beschaltungsnetzwerks in sich vereint, und das montagetechnisch kompatibel zu Leistungshalbleitern ist, so dass es wie ein Leistungshalbleiter effektiv gekühlt und niederinduktiv parallel zu Leistungshalbleiterchips geschaltet werden kann. Als Reaktanzstrukturen können erfindungsgemäße kapazitive oder induktive Strukturen vorgesehen sein.

Bei bevorzugten Ausführungsbeispielen umfasst das integrierte Beschaltungsbauelement eine Serienschaltung aus Widerstand und Kapazität, eine Parallelschaltung aus Widerstand und Kapazität und seriell dazu eine Diode, oder eine Parallelschaltung aus Widerstand und Diode und seriell dazu eine Kapazität. Ein die Kapazität realisierender Kondensator ist vorzugsweise in das Element integriert, indem eine Elektrode desselben als ein Halbleiterbereich ausgebildet ist, der direkt oder über zumindest einen Halbleiterbereich mit einem Anschluss verbunden ist. Ein Widerstandswert der Widerstandsstruktur kann dann vorteilhaft über die Dotierung des Halbleiterbereichs, der die Elektrode der Kapazität darstellt eingestellt werden. Typische Dotierungskonzentrationen hierfür können zwischen 10¹³ cm⁻³ und 10¹⁹ cm⁻³ liegen.

Ein Beschaltungsnetzwerk in Form eines einzigen Bauelements kann zudem die Montagekosten reduzieren und - aufgrund der reduzierten Anzahl an Verbindungsstellen - auch die Systemzuverlässigkeit erhöhen. Ein Beschaltungsnetzwerk, das die oben beschriebenen Elemente enthält und einen geringen Flächenverbrauch besitzt, kann darüber hinaus auch für Anwendungen auf IC-Ebene z.B. in Smart-Power-Chips von Vorteil sein.

Ein erfindungsgemäßes integriertes Snubber-Bauelement weist erhebliche Vorteile gegenüber dem Stand der Technik auf. Es stellt einen Hochtemperaturkondensator mit hervorragenden Bauelementeeigenschaften mit einem integrierten und exakt einstellbaren Serienwiderstand dar. Es bietet die Freiheitsgrade weitere Bestandteile eines Snubber-Netzwerkes mit integrieren zu können oder diskret zu ergänzen. Es kann sogar als Modul in einen Herstellungsprozess einer Smart-Power-Schaltung eingefügt werden.

Durch die Verwendung der Halbleitertechnologie ist es möglich, eine Flächen- und damit Kapazitätsvergrößerung der Snubber-Kondensatoren pro Substratgrundfläche zu erzielen. Dies und die Nutzung von Hoch-Epsilon-Dielektrika ermöglichen eine deutliche Senkung der Herstellungskosten im Vergleich zu herkömmlichen Halbleiterbauelementen.

Für viele Anwendungsfälle (z.B. in Leistungsmodulen) ist es notwendig, dass die Beschaltungsbauelemente auch bei Temperaturen deutlich oberhalb von 100°C noch einsatzfähig sind. In diesem Temperaturbereich kommen derzeit fast ausschließlich Keramikkondensatoren zum Einsatz. Die gebräuchlichen Keramiken wie X7R, Z5U oder Y5V führen zu erheblichen Spannungs- und Temperatur-Abhängigkeiten der Kapazitätswerte, wobei im Betrieb Änderungen der Kapazität um bis zu 70% und mehr auftreten können.

Erfindungsgemäße Beschaltungsbauelemente mit einem in Silizium integrierten Kondensator besitzen demgegenüber eine überragende Temperaturstabilität und einen weiten Einsatztemperaturbereich. Die Temperaturabhängigkeit des Kapazitätswerts bezogen auf den Wert bei 25°C beträgt nur etwa 20ppm/°C. Die hohen zulässigen Dauer-Einsatztemperaturen von typisch 175°C (Beschaltungsbauelemente mit Diodenstrukturen) bzw. 200°C (bei passiven RC-Netzwerken) machen, in Verbindung mit der hohen Stabilität des Kapazitätswerts und der überragenden thermischen Belastbarkeit bei kleinstem Bauvolumen, die erfindungsgemäß integrierten Beschaltungsbauelemente heutigen Lösungen weit überlegen.

Für den Anwender bieten die erfindungsgemäßen Beschaltungsbauelemente neben ihren überragenden thermischen und hochfrequenztechnischen Eigenschaften auch Einsparungen an Platz, Gewicht und Kosten, reduzierten Montageaufwand und erhöhte Systemzuverlässigkeit durch den Wegfall von Lötverbindungen. Damit stehen erstmals Beschaltungsbauelemente auch für den höheren Leistungsbereich zur Verfügung, die alle Anforderungen an derartige Bauelemente in hervorragender Weise erfüllen.

Bevorzugte Ausführungsbeispiele der vorliegenden Erfindung werden nachfolgend bezugnehmend auf die beiliegenden Zeichnungen näher erläutert. Es zeigen:
- Fig. 1a: ein Beispiel eines Serienschwingkreises bestehend aus den Elementen L, C und einem Dämpfungswiderstand R;
- Fig. 1b: Sprungantworten des Serienschwingkreises für unterschiedliche Dämpfungen;
- Fig. 2: ein zu beschaltendes Netzwerk mit drei möglichen Beschaltungsnetzwerken;
- Fig. 3a: eine schematische Darstellung eines Ausführungsbeispiels eines erfindungsgemäßen Beschaltungsbauelements und Fig. 3b ein durch ein Beschaltungsbauelement gemäß Fig. 3a implementiertes Dämpfungsnetzwerk;
- Fig. 4a: eine schematische Darstellung eines weiteren Ausführungsbeispiels eines erfindungsgemäßen Beschaltungsbauelements und Fig. 4b ein durch ein Beschaltungsbauelement gemäß Fig. 4a implementiertes Dämpfungsnetzwerk;
- Fig. 5a: eine schematische Darstellung eines weiteren Ausführungsbeispiels eines erfindungsgemäßen Beschaltungsbauelements und Fig. 5b ein durch ein Beschaltungsbauelement gemäß Fig. 5a implementiertes Spannungsbegrenzernetzwerk;
- Fig. 6a und Fig. 6b: schematische Darstellungen weiterer Ausführungsbeispiele eines erfindungsgemäßen Beschaltungsbauelements und Fig. 6c ein dadurch implementiertes Spannungsbegrenzernetzwerk;
- Fig. 7a und Fig. 7b: schematische Darstellungen weiterer Ausführungsbeispiele eines erfindungsgemäßen Beschaltungsbauelements und Fig. 7c ein dadurch implementiertes dV/dt-Begrenzernetzwerk;
- Fig. 8a und Fig. 8b: schematische Darstellungen zur Veranschaulichung möglicher Anwendungen eines erfindungsgemäßen Beschaltungsbauelements;
- Fig. 9: eine schematische Darstellung zur Veranschaulichung einer Anwendung eines erfindungsgemäßen Beschaltungsbauelements in einem sog. PresspackGehäuse; und
- Fig. 10: eine mögliche Ausführungsform des erfindungsgemäßen Beschaltungsbauelements als zweipoliges SMD-Bauelement.

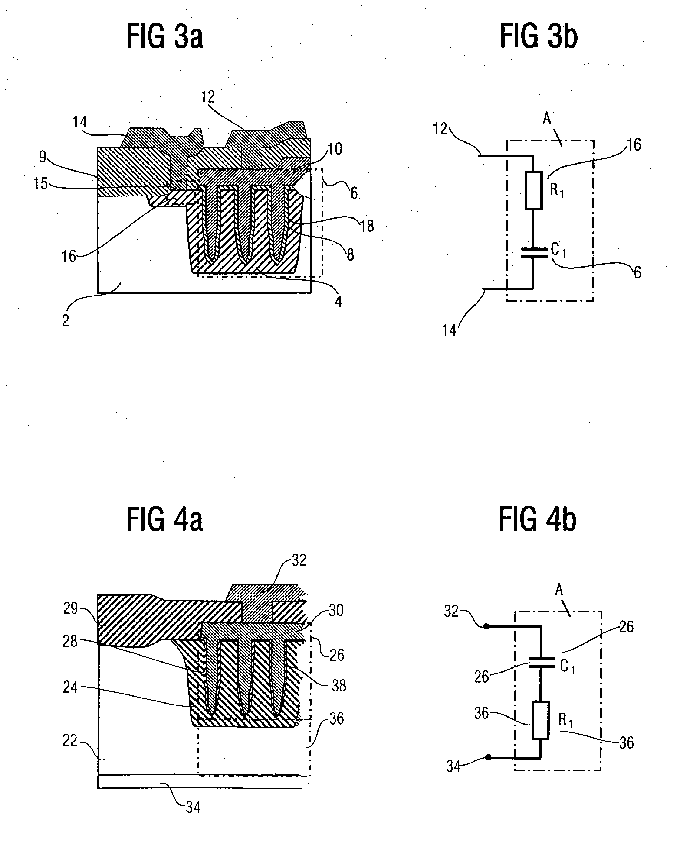

Fig. 3a zeigt eine Querschnittansicht eines erfindungsgemäßen Ausführungsbeispiels eines integrierten Beschaltungsbauelements, das ein Dämpfungsnetzwerk, wie es in Fig. 3b gezeigt ist, implementiert. Das integrierte Beschaltungsbauelement umfasst einen Halbleiterchip 2, in dem ein Halbleiterbereich 4 definiert ist, der eine untere Elektrode einer Kondensatorstruktur 6 darstellt. Die Kondensatorstruktur 6 umfasst ferner eine Dielektikumschicht 8 und eine obere Elektrode 10, wobei die Dielektikumschicht 8 zwischen der oberen Elektrode 10 und dem Substratbereich 4 angeordnet ist. Die obere Elektrode 10 ist mit einem ersten Kontakt 12 leitfähig verbunden und der Substratbereich 4 ist mit einem zweiten Kontakt 14 leitfähig verbunden. Die Kontakte 12 und 14 sind im übrigen durch eine isolierende Schicht 9 von dem Substrat 2 isoliert. Durch den Halbleiterbereich 4 wird eine Widerstandsstruktur 16 zwischen dem Kondensatorbereich 6 und dem Anschluss 14 gebildet.

Bei dieser Ausführungsform liegen ein Kontakt 12 für die obere Elektrode und der Kontakt 14 für die untere Elektrode der Kondensatorstruktur auf der Chip-Oberseite. Das RC-Dämpfungsnetzwerk besteht aus einem Kondensator 6 und einem in Serie geschalteten Widerstand 16. Dieser definiert sich aus der Dotierung des Halbleiterbereichs 4 und der Struktur der Kontaktgeometrie. Der Widerstandswert lässt sich durch veränderte Dotierung und/oder Variation der Dicke des Substratmaterials nahezu beliebig einstellen. Durch die Integration in einen Halbleiterchip wird ein hervorragendes Temperaturverhalten erzielt.

In einer nicht dargestellten Ausführungsform eines erfindungsgemäßen integrierten Beschaltungsbauelements kann die Widerstandsstruktur auch mittels zusätzlicher Leiterbahnen (z.B. aus dotiertem Polysilizium oder Metall) zwischen dem Halbleiterbereich 4 und dem Kontakt 14, oder einer Zuleitung und Kontakt 12 erzeugt werden. Der Widerstandswert lässt sich dann über Breite, Dicke und/oder Dotierung der Leiterbahnen beliebig einstellen.

Fig. 4a zeigt eine Querschnittansicht eines weiteren, besonders vorteilhaften erfindungsgemäßen Ausführungsbeispiels eines integrierten Beschaltungsbauelements, das ein Dämpfungsnetzwerk, wie es in Fig. 4b gezeigt ist, implementiert. Das integrierte Beschaltungsbauelement umfasst einen Halbleiterchip 22, in dem ein Halbleiterbereich 24 definiert ist, der eine untere Elektrode einer Kondensatorstruktur 26 darstellt. Die Kondensatorstruktur 26 umfasst ferner eine Dielektikumsschicht 28 und eine obere Elektrode 30, wobei die Dielektikumsschicht 28 zwischen der oberen Elektrode 30 und dem Substratbereich 24 angeordnet ist. Die obere Elektrode 30 ist mit einem ersten Kontakt 32 leitfähig verbunden und der Substratbereich 22 ist mit einem zweiten Kontakt 34 leitfähig verbunden. Durch den Halbleiterbereich 22, 24 zwischen dem Anschluss 34 und dem Kondensatorbereich 26 ist eine Widerstandsstruktur 36 zwischen dem Kondensatorbereich 26 und dem Anschluss 34 gebildet. Der als untere Elektrode des Kondensators wirkende Halbleiterbreich 24 wird in der Regel höher dotiert sein als das Substrat.

Bei dieser Ausführungsform des erfindungsgemäßen Beschaltungsbauelements liegen ein Kontakt 32 der oberen Elektrode auf der Chip-Oberseite und ein Kontakt 34 der unteren Elektrode auf der Chip-Unterseite. Die großflächig ausgeführte Widerstandsstruktur 36 führt zu einem sehr hoch belastbaren Bauelement mit hervorragenden thermischen Eigenschaften. Der Widerstandswert der Widerstandsstruktur 36 ist im Wesentlichen definiert durch die Flächen der Kontaktbereiche zwischen Halbleiterbereich 24, Substratbereich 22 und Kontakt 34, der Dotierung des Halbleiterbereichs 24 und der Dicke und Dotierung des Substratbereichs 22 zwischen Halbleiterbereich 24 und Kontakt 34.

Die Bauelemente nach Fig. 3a und 4a sind monolithisch in einen Halbleiter integriert. Sie bestehen aus einer Kondensatorstruktur 6,26 und einem in Serie geschalteten Widerstand 16,36. Der Kondensator besteht jeweils aus einer oberen 10,30 und einer unteren Elektrode 4,24. Zwischen den beiden Elektroden befindet sich ein Dielektrikum 8,28. Das Halbleitermaterial wird mit Hilfe von bevorzugt anisotropen Ätzprozessen (z.B. durch Trockenätzen oder naßchemisch) strukturiert, wodurch dessen Oberfläche um ein Vielfaches vergrößert werden kann. Bei den Strukturen handelt es sich vorzugsweise um Lochgeometrien, es sind aber genauso Säulengeometrien oder Streifen-/Grabengeometrien oder sonstige die Oberfläche vergrößernde Geometrien möglich. Die zuvor beschriebene strukturierte Halbleiteroberfläche 18,38, dient als Basisfläche für den Kondensator, dessen Aufbau auf dieser Fläche vorgenommen wird.

Im Hinblick auf weitere Ausführungsformen kann die untere Elektrode 4,24 entweder das Substrat mit einer bestimmten spezifischen Leitfähigkeit sein oder das Substrat kann durch eine zusätzliche Dotierung in seiner Leitfähigkeit moduliert sein. Die für derartige Dämpfungsnetzwerke typischen Widerstandswerte im Bereich von einigen hundert Milli-Ohm bis zu einigen zehn Ohm lassen sich auf diese Weise hervorragend realisieren. Die untere Elektrode 4,24 kann aber auch aus einer zusätzlichen Schicht mit einer anderen spezifischen Leitfähigkeit bestehen. Das Dielektrikum 8,28 wird entweder durch Oxidation aus dem Substrat gewonnen oder es wird eine zusätzliche Schicht mit dielektrischen Eigenschaften auf die untere Elektrode 4,24 abgeschieden oder aufgebracht. Die obere Elektrode 10,30 besteht aus einer weiteren Schicht mit einer spezifischen Leitfähigkeit. Die beiden Elektroden werden mit einem stromleitfähigen Material kontaktiert (vorzugsweise eine metallische Schicht oder dotiertes Polysilizium), dies entspricht den beiden zu Beginn des Abschnitts beschriebenen Kontakten 12,32 und 14,34.

Die Halbleitertechnologie ermöglicht die Strukturierung des Substrates und somit eine Vergrößerung der Chip-Oberfläche. Diese Vergrößerung, sowie die Möglichkeit des Einsatzes von Materialien mit hoher Dielektrizitätskonstante (sog. Hoch-Epsilon Materialien) als Dielektrikum 8,28 senken in hohem Maß die Herstellungskosten der erfindungsgemäßen Beschaltungsbauelemente. Des Weiteren ist es möglich, die erfindungsgemäß integrierten Beschaltungsnetzwerke auch in Smart-Power Schaltungen oder in Leistungshalbleiter-Chips zu integrieren.

Ein erfindungsgemäßes Bauelement kann weitere Elemente eines Beschaltungsnetzwerks (wie Dioden oder Widerstände) monolithisch integriert enthalten.

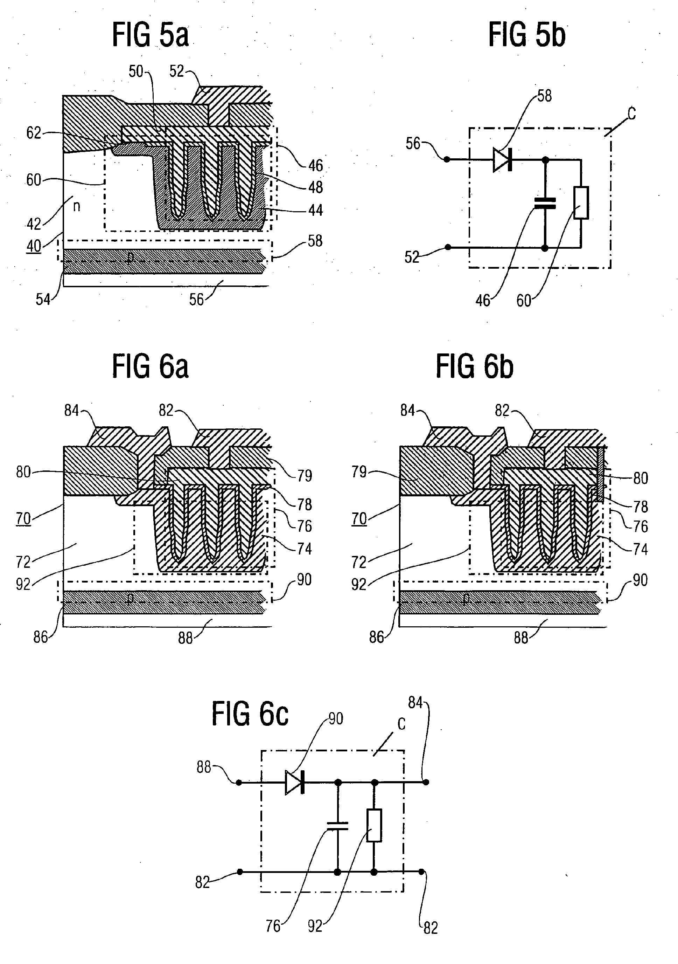

Fig. 5a zeigt eine Querschnittansicht eines weiteren, erfindungsgemäßen Ausführungsbeispiels eines integrierten Beschaltungsbauelements, das ein Spannungsbegrenzernetzwerk, wie es in Fig. 5b gezeigt ist, implementiert. Das integrierte Beschaltungsbauelement umfasst einen Halbleiterchip 40, in dem ein n-dotierter Halbleiterbereich 42 gebildet ist. Der n-dotierte Substratbereich 42 weist einen zweiten Halbleiterbereich 44 auf, der in der Regel höher dotiert sein wird als der Bereich 42 und der eine untere Elektrode einer Kondensatorstruktur 46 darstellt. Die Kondensatorstruktur 46 umfasst ferner eine Dielektikumsschicht 48 und eine obere Elektrode 50, wobei die Dielektrikumsschicht 48 zwischen der oberen Elektrode 50 und dem Substratbereich 44 angeordnet ist. Die obere Elektrode 50 ist mit einem ersten Kontakt 52 und dem Halbleiterbereich 44 leitfähig verbunden. Ein p-dotierter Substratbereich 54 ist mit einem zweiten Kontakt 56 leitfähig verbunden. Durch den p-dotierten Substratbereich 54 und den n-dotierten Bereich 42 ist eine pn-Diodenstruktur 58 definiert. Der Halbleiterbereich 44 definiert einen Widerstandsbereich 60, der einen parallel zu der Kondensatorstruktur 46 geschalteten Widerstand darstellt.

Gemäß Fig. 5a wird die Reihenschaltung des Kondensators 46 und der Diode 58 dabei realisiert, indem die Diode vertikal integriert wird, d.h. dem Kondensator 46 vorgeschaltet wird. Der zum Kondensator parallel liegende Widerstand 60 wird über einen ohmschen Kontakt 62 auf der Oberseite des Substrates, Substratdotierung bzw. Dotierung des Bereichs 44 und die aktiven Flächen definiert.

Weitere Ausführungsformen eines erfindungsgemäßen Beschaltungsbauelements ergeben sich durch eine laterale Reihenschaltung eines pn-Übergangs oder einer pin-Struktur und einer Kondensatorstruktur. Eine andere Möglichkeit zur Realisierung des Widerstandes bietet der Einsatz von dielektrischen Schichten, die hohe Leckströme zulassen. Dies ist in der Regel bei sog. Hoch-Epsilon Schichten der Fall. So wird es möglich, einen großflächigen Widerstand mit niedrigem Wärmewiderstand zu erzielen, was zu einem wesentlich höher belastbaren Bauelement führt, als wenn z.B. nur die Randstruktur des Kondensatorfelds leitfähig wäre. Es ist hierzu von Vorteil, das Dielektrikum gezielt leitfähig zu machen, um die Temperaturabhängigkeit des Widerstandswerts zu reduzieren. Außerdem könnte der zum Kondensator parallel liegende Widerstand über so genannte Vias, d.h. Durchkontaktierungen, die durch die ganze Dicke des Substrates führen, realisiert werden.

Fig. 6a zeigt eine Querschnittansicht eines weiteren, erfindungsgemäßen Ausführungsbeispiels eines integrierten Beschaltungsbauelements, das ein Spannungsbegrenzernetzwerk, wie es in Fig. 6c gezeigt ist, implementiert. Das integrierte Beschaltungsbauelement umfasst einen Halbleiterchip 70, in dem ein n-dotierter Halbleiterbereich 72 definiert ist. Der n-dotierte Substratbereich 72 weist einen Halbleiterbereich 74 auf, der eine untere Elektrode einer Kondensatorstruktur 76 darstellt. Die Kondensatorstruktur 76 umfasst ferner eine Dielektikumsschicht 78 und eine obere Elektrode 80, wobei die Dielektrikumsschicht 78 zwischen der oberen Elektrode 80 und dem Substratbereich 74 angeordnet ist. Die obere Elektrode 80 ist mit einem ersten Kontakt 82 leitfähig verbunden und der Substratbereich 74 ist mit einem zweiten Kontakt 84 leitfähig verbunden. Die Kontakte 82 und 84 sind im übrigen durch eine isolierende Schicht 79 von dem Substrat 72 isoliert. Ein p-dotierter Substratbereich 86 ist mit einem zweiten Kontakt 88 leitfähig verbunden. Durch den Kontaktbereich zwischen dem p-dotierten Substratbereich 86 und dem n-dotierten Substratbereich 72 ist ein pn-Diodenstruktur 90 definiert. Bei dem in Fig. 6a gezeigten Ausführungsbeispiel wird der Widerstand 92 der in Fig. 6c dargestellten Parallelschaltung aus Kapazität 76 und Widerstand 92 durch den Kontaktbereich zwischen der oberen Elektrode 80, der Dielektrikumsschicht 78 und dem Halbleiterbereich 74 gebildet. Bei dem in Fig. 6a gezeigten Ausführungsbeispiel ist ein Dielektrikum verwendet, das eine geringe Leitfähigkeit besitzt, wie dies beispielsweise bei Hoch-Epsilon-Schichten der Fall ist, so dass dasselbe neben einer Kapazität einen parallelen Widerstand darstellt, so dass der Widerstandswert des zwischen die Anschlüsse 82 und 84 geschalteten Widerstands 92 im Wesentlichen durch diese Eigenschaft des Dielektrikums 80 bestimmt ist.

Ein weiteres Ausführungsbeispiel gemäß vorliegender Erfindung ist in Fig. 6b dargestellt, welches ebenfalls ein Beschaltungsbauelement zeigt, das ein Spannungsbegrenzernetzwerk, wie es in Fig. 6c gezeigt ist, realisiert. Das integrierte Beschaltungsbauelement umfasst einen Halbleiterchip 70, in dem ein n-dotierter Halbleiterbereich 72 definiert ist. Der n-dotierte Substratbereich 72 weist einen Halbleiterbereich 74 auf, der eine untere Elektrode einer Kondensatorstruktur 76 darstellt. Die Kondensatorstruktur 76 umfasst ferner eine Dielektikumsschicht 78 und eine obere Elektrode 80, wobei die Dielektrikumsschicht 78 zwischen der oberen Elektrode 80 und dem Substratbereich 74 angeordnet ist. Ein erster Kontakt 82 ist mit der oberen Elektrode 80 und dem Halbleiterbereich 74 leitfähig verbunden. Zusätzlich ist der Substratbereich 74 mit einem zweiten Kontakt 84 leitfähig verbunden. Die Kontakte 82 und 84 sind im übrigen durch eine isolierende Schicht 79 von dem Substrat 72 isoliert. Ein p-dotierter Substratbereich 86 ist mit einem zweiten Kontakt 88 leitfähig verbunden. Durch den Kontaktbereich zwischen dem p-dotierten Substratbereich 86 und dem n-dotierten Substratbereich 72 ist ein pn-Diodenstruktur 90 definiert. Bei dem in Fig. 6b gezeigten Ausführungsbeispiel wird der Widerstand 92 der in Fig. 6c dargestellten Parallelschaltung aus Kapazität 76 und Widerstand 92 durch den Halbleiterbereich 74 gebildet. D.h. der Widerstandswert des zwischen die Anschlüsse 82 und 84 geschaltenten Widerstands 92 wird durch die Dotierung des Halbleiterbereich 74 bestimmt.

Bei den beiden letztgenannten Ausführungsformen ist das erfindungsgemäße Beschaltungsbauelement als Dreipol realisiert. Dies ist dann vorteilhaft, wenn einzelne Elemente der Schaltungsnetzwerke keinen besonderen dynamischen Anforderungen, wie z.B. R₃ im Netzwerk C Fig. 2, unterliegen und/oder eine Möglichkeit zur Anpassung der Eigenschaften des Beschaltungsnetzwerks an die Anwendungsanforderung geschaffen werden soll (Reduzierung der Variantenvielfalt). Mit den in Fig. 6a,b dargestellten Ausführungsformen ist es möglich, externe Beschaltungselemente, z.B. einen weiteren Widerstand, Kondensator oder eine Z-Diode, zu ergänzen. Durch Beschaltung mit einem externen Widerstand zwischen den Anschlüssen 82 und 84 kann beispielsweise das Klemmspannungsniveau an die konkrete Anwendung angepasst werden.

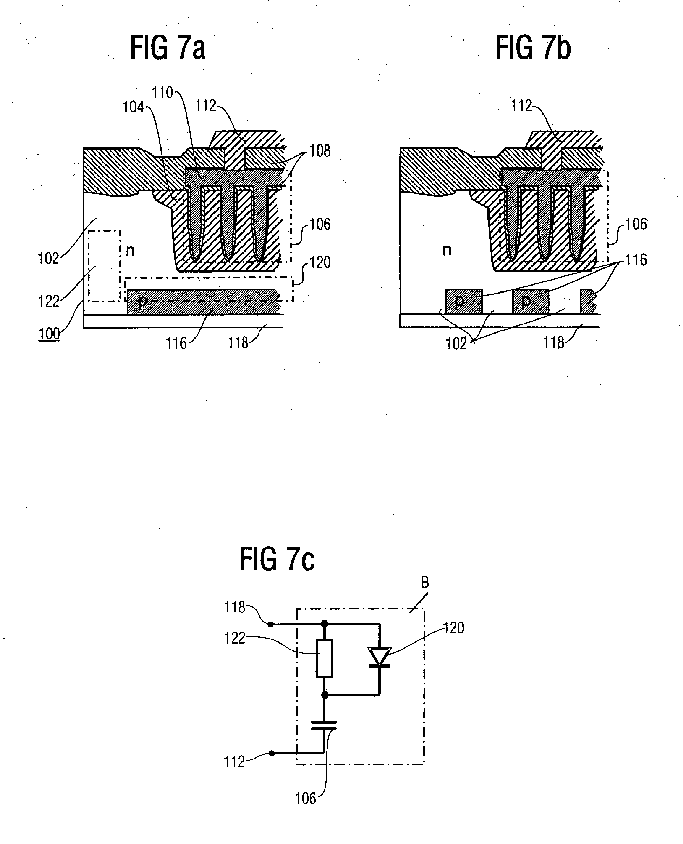

Fig. 7a zeigt eine Querschnittansicht eines weiteren, erfindungsgemäßen Ausführungsbeispiels eines integrierten Beschaltungsbauelements, das ein dV/dt-Begrenzernetzwerk, wie es in Fig. 7c gezeigt ist, implementiert. Das integrierte Beschaltungsbauelement umfasst einen Halbleiterchip 100, in dem ein n-dotierter Halbleiterbereich 102 definiert ist. Der n-dotierte Substratbereich 102 weist einen Halbleiterbereich 104 auf, der eine untere Elektrode einer Kondensatorstruktur 106 darstellt. Die Kondensatorstruktur 106 umfasst ferner eine Dielektikumsschicht 108 und eine obere Elektrode 110, wobei die Dielektrikumsschicht 108 zwischen der oberen Elektrode 110 und dem Substratbereich 104 angeordnet ist. Die obere Elektrode 110 ist mit einem ersten Kontakt 112 leitfähig verbunden. Ein p-dotierter Substratbereich 116 ist mit einem zweiten Kontakt 118 leitfähig verbunden. Durch den Kontaktbereich zwischen dem P-dotierten Substratbereich 116 und dem n-dotierten Bereich 102 ist ein pn-Diodenstruktur 120 definiert. Durch die Leitfähigkeit des n-dotierten Substratbereich 102 ist eine Widerstandsstruktur 122 zwischen dem Anschluss 118 und der unteren Elektrode der Kondensatorstruktur 104 gebildet.

Diese Ausführungsform realisiert das Beschaltungsnetzwerk B nach Fig. 2. Hierbei wird die Reihenschaltung des Kondensators und des Widerstands analog zu der in Fig. 4a gezeigten und beschriebenen Struktur technologisch realisiert. Ist der Widerstand Teil der Substratdotierung, kann dieser z.B. durch Verwendung von SOI-Substratmaterial und lateraler Isolation (z.B. Trench-Isolation) elektrisch abgegrenzt werden. Analog sind diese Isolationsmöglichkeiten auch zur elektrischen Abgrenzung der Diode von den anderen Bauelementen einsetzbar. Für die technologische Umsetzung der Reihenschaltung von Widerstand und Kondensator nach der Variante aus Fig. 4a, wird die Diode als vertikale Struktur in Parallelschaltung zum Widerstand 122 realisiert. Dies kann so ausgeführt werden, dass ein Teil des Substratmaterials des Kontaktbereiches der unteren Elektrode mit einem Dotierstoff dotiert wird, der diesen Bereich umdotiert, d.h. mit einer anderen Leitfähigkeit versieht, als das Substratmaterial (z.B. Substrat ist n-leitend, Diodenkontaktbereich ist p-leitend, vgl. Fig. 7a). Der andere Teil des Kontaktbereiches wird als ohmscher Kontakt realisiert.

Die beiden Bereiche können z.B. - wie bei dem Ausführungsbeispiel von Fig. 7b angedeutet - in Form von Streifenstrukturen, als konzentrische Kreisstrukturen oder als regulär oder statistisch angeordnete Inseln angeordnet sein. Durch geeignete Wahl des Abstands der - im Beispiel p-dotierten - Dioden-Inseln 116 kann eine gezielt nichtlineare Charakteristik des Widerstandswerts als Funktion der Dioden-Sperrspannung erzielt werden. Dies ist besonders vorteilhaft, da ein hoher Widerstandswert zum Zeitpunkt eines negativen Spannungssprungs an den Klemmen dieses Netzwerks (112, 118) den einschaltenden Schalter entlastet (vgl. Fig. 2), zugleich aber der mit abnehmender Kondensatorspannung stark sinkende Widerstandswert zu einer kurzen Entladezeit des Kondensators führt. Die erforderliche Entladezeit schränkt in der Anwendung die minimale Einschaltzeit des Schalters (und damit das minimale Tastverhältnis) ein und sollte deshalb so kurz wie möglich sein. Nach dem Stand der Technik (linearer (ohmscher) Widerstand) sind nur unzureichende Kompromisse zwischen Einschaltbelastung und Entladezeit möglich.

Falls bei weiteren Ausführungsformen eines erfindungsgemäßen Beschaltungsbauelements eine applikationsbedingte elektrische Trennung des Widerstands- und Diodenbereiches erforderlich ist, so können die Bereiche durch Strukturierung des Substrates (z.B. durch tiefe anisotrope Trockenätzprozesse) abgegrenzt werden. Die Strukturen können so ausgeführt sein, dass sie entweder sog. Vias, d.h. Lochstrukturen die durch das Substrat geätzt wurden, an den Seitenwänden mit einem elektrischen Isolator beschichtet und im Kern mit leitfähigem Material (z.B. dotiertes Polysilizium oder Metall) gefüllt sind, oder es sind den Diodenbereich begrenzende Strukturen, die mit elektrisch isolierendem Material gefüllt sind.

Bei den Diodenstrukturen handelt es sich, je nach Spannungsanforderung um pn-Übergänge (für kleinere Spannungen bis etwa 50V) oder pin-Diodenstrukturen (für höhere Spannungen). Die Einstellung der Spannungsfestigkeit der pin-Dioden erfolgt, wie allgemein für Leistungsdioden üblich, über die Breite des i-Gebietes (sog. intrinsisches Gebiet). Dieses kann durch Festlegung der Elektrodenabstände im Maskendesign oder durch Tiefendiffusion und/oder Substratdünnung (Fall nach Fig. 4a) sichergestellt werden. Die Stromtragfähigkeit der Diodenstrukturen wird über deren aktive Kontaktflächen eingestellt.

Bei einem weiteren Ausführungsbeispiel kann die Diodenstruktur, wie im Fall der Realisierung nach Fig. 3a, als laterale Diode zur Widerstandsstruktur parallel geschaltet werden. Der Widerstand und die laterale Diode können anhand von Isolationsschichten (z.B. Siliziumdioxid oder Siliziumnitrid) elektrisch getrennt werden.

Ist der Widerstand in einem weiteren Ausführungsbeispiel als Leiterbahn realisiert, so wird eine Isolationsschicht auf dem Substrat abgeschieden und liegt zwischen Substrat (Diode) und Leiterbahn.

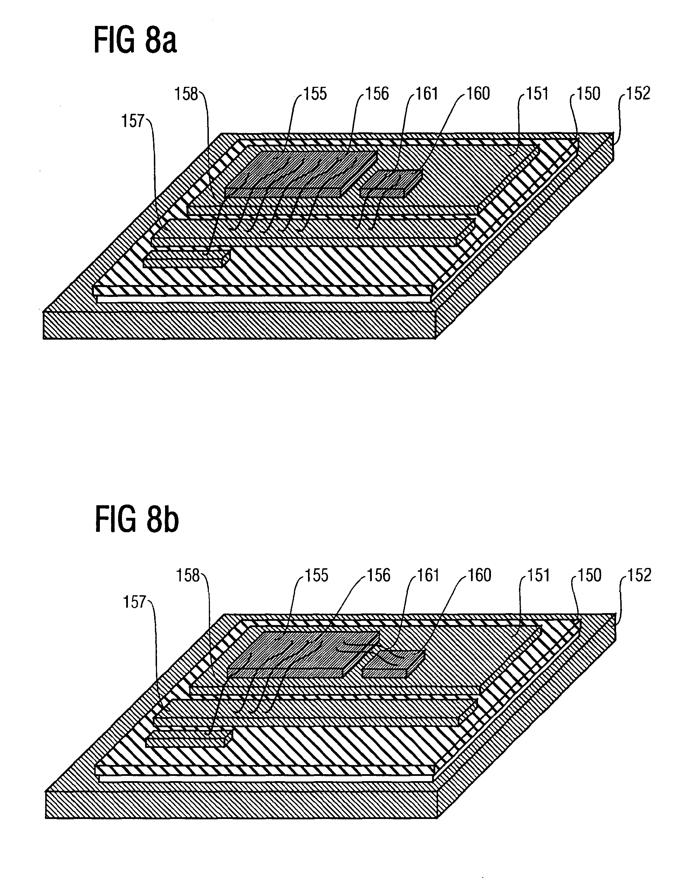

Fig. 8a zeigt beispielhaft eine mögliche Anwendung eines erfindungsgemäßen Beschaltungsbauelements. Ein Keramiksubstrat 150, das auf einer Wärmesenke 152 montiert ist, besitzt auf seiner Oberfläche metallische Leiterstrukturen (151, 157) auf denen ein oder mehrere Leistungshalbleiterchips 155 montiert sind. Der Chip 155 kann eine Diode oder ein steuerbarer Schalter (z.B. ein IGBT oder MOSFET mit einem Steueranschluss 158) sein. Ist der Chip 155 ein vertikaler MOSFET, dann entspricht 151 dem Drain-Anschluss, der Source-Anschluss wird über die Bonddrähte 156 auf die Leiterbahn 157 kontaktiert. Das Beschaltungsbauelement 160 realisiert dabei eine der Topologien A, B oder C aus Fig. 2 - oder eine andere problemangepasste Topologie.

Wie bereits in Fig. 2 angedeutet, liegen die Beschaltungsbauelemente im Allgemeinen unmittelbar parallel zu den Leistungshalbleitern in einer Schaltung (Dioden oder Schalter). Um Schwingungen möglichst effizient unterdrücken zu können, muss die Verbindung zwischen Leistungshalbleiter und Beschaltungsbauelementen so niederinduktiv wie irgend möglich erfolgen. Da ein erfindungsgemäß integriertes Beschaltungsbauelement aufbautechnisch kompatibel zu Leistungshalbleitern ist, sind eine niederinduktive Ankopplung an den Leistungshalbleiter und eine effektive Kühlung - im Gegensatz zu den Möglichkeiten nach dem Stand der Technik - sehr einfach zu realisieren.

Da ein erfindungsgemäßes Beschaltungsbauelement 160 auf der Chip-Unterseite genau den elektrischen Anschluss besitzt, der elektrisch mit der Chip-Unterseite des Leistungshalbleiters 155 verbunden gehört, kann das erfindungsgemäße Beschaltungsbauelement unmittelbar neben den Leistungshalbleiterchip 155 auf die gleiche Kupferfläche 151 montiert werden. Die Kontaktierung kann parallel zu der des Leistungshalbleiters über Bonddrähte 161 auf die mit der Oberseite des Leistungshalbleiters verbundene Leiterbahn 157 erfolgen.

Bei sehr schnell schaltenden Leistungshalbleitern (MOSFET, Schottky-Dioden) oder sehr hartnäckigen und hochfrequenten Oszillationen ist bei einer weiteren möglichen Ausführungsform auch eine direkte Kontaktierung der Oberseite des Beschaltungsbauelements auf die Oberseite des Leistungshalbleiters möglich, wie dies in Fig. 8b angedeutet ist.

Dem Fachmann ist bekannt, dass die Oberseiten-Kontaktierung nicht nur mittels Drahtbondens möglich ist, sondern in weiteren Ausführungsbeispielen auch metallische Bügel, Bändchen oder Folien eingesetzt werden können, die durch Löten, Leitkleben oder Sinterprozesse mit der Chip-Oberseite elektrisch leitfähig verbunden werden können.

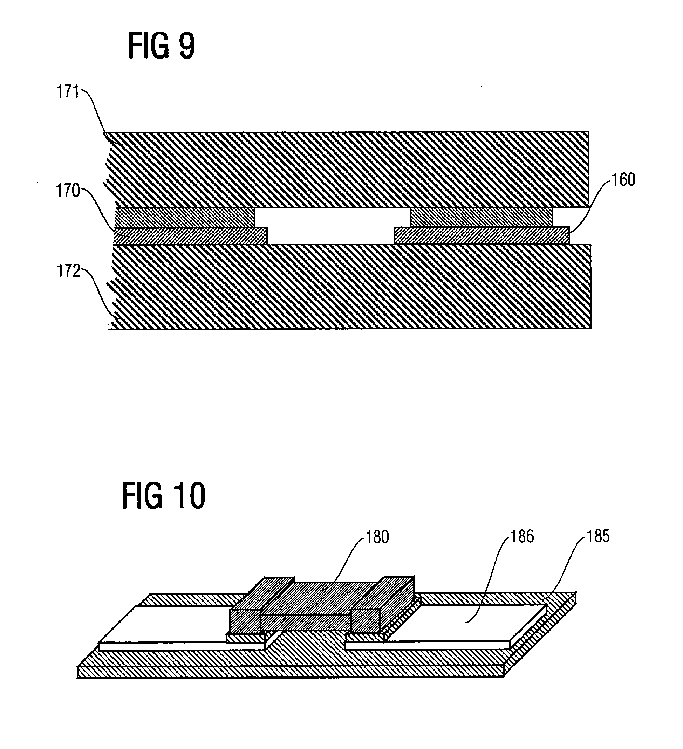

Fig. 9 zeigt schematisch eine weitere mögliche Anwendung eines erfindungsgemäßen Beschaltungsbauelements, hier in einem so genannten Presspack-Gehäuse. Derartige Gehäuse werden für Dioden, Thyristoren, GTOs oder IGBTs im höheren Leistungsbereich und bei hohen Anforderungen an die Lastwechselfestigkeit eingesetzt. Bei diesem Gehäusetyp wird der Leistungshalbleiter 170 zwischen metallische Elektroden 171 und 172, die die Ober- und Unterseite des Chips 170 kontaktieren, gepresst. Ein erfindungsgemäßes Beschaltungsbauelement 160 ist aufbautechnisch voll kompatibel zu dem Leistungshalbleiter 170 und kann zusammen mit diesem zwischen die Elektroden 171 und 172 gepresst und entsprechend kontaktiert werden. Damit ist eine mit heutigen Lösungen unerreichte elektrische und thermische Leistungsfähigkeit erzielbar.

Fig. 10 zeigt eine mögliche Ausführungsform des Beschaltungsbauelements als zweipoliges diskretes SMD-Bauelement 180, montiert auf einem Schaltungsträger 185 und kontaktiert über elektrische Leiterbahnen 186.

Dem Fachmann ist unmittelbar einsichtig, dass ein erfindungsgemäßes Beschaltungsbauelement auch als diskretes elektronisches Bauelement gehäust werden kann. Für hoch belastbare Beschaltungsbauelemente kommen vorteilhaft Gehäusebauformen mit metallischer Kühlfahne wie z.B. das D-Pak (TO-252) in Frage, für bis in sehr hohe Frequenzbereiche wirksame Beschaltungsbauelemente sind extrem niederinduktive Gehäuse (z.B. BGA oder PLCC) zu bevorzugen.

## Patentansprüche

1. Integriertes Beschaltungsbauelement auf Halbleiterbasis zur Beschaltung eines elektrischen Netzwerkes zur Absorption von elektrischer Energie aus einem elektrischen Energiespeicher eines elektrischen Netzwerkes, mit folgenden Merkmalen:
zumindest zwei Anschlüssen (12,14; 32,34; 52,56; 82,84,88; 112,118) zum Anschluss an das zu beschaltende, elektrische Netzwerk,
eine elektrischen Widerstandsstruktur (16; 36; 60; 92; 122) und einer Reaktanzstruktur (6; 26; 46; 76; 106), die zwischen die Anschlüsse geschaltet sind.

2. Integriertes Beschaltungsbauelement gemäß Anspruch 1, bei dem die Reaktanzstruktur als Kondensatorstruktur (6; 26; 46; 76; 106) ausgebildet ist.

3. Integriertes Beschaltungsbauelement gemäß Anspruch 2, bei dem die Kondensatorstruktur (6; 26; 46; 76; 106) einen dotierten Halbleitersubstratbereich (4; 24; 44; 74; 104) aufweist, der eine erste Elektrode der Kondensatorstruktur bildet, wobei auf dem dotierten Halbleiter-Substratbereich eine dielektrische Schicht (8; 28; 48; 78; 108) angeordnet ist, die den Halbleitersubstratbereich konform bedeckt und auf der dielektrischen Schicht eine leitfähige Schicht (10; 30; 50; 80; 110) angeordnet ist, die eine zweite Elektrode der Kondensatorstruktur bildet.

4. Integriertes Beschaltungsbauelement gemäß einem der vorhergehenden Ansprüche, bei dem der Halbleitersubstratbereich (4; 24; 44; 74; 104), die dielektrische Schicht (8; 28; 48; 78; 108) und die leitfähige Schicht (10; 30; 50; 80; 110) planar angeordnet sind.

5. Integriertes Beschaltungsbauelement gemäß einem der Ansprüche 1 bis 3, bei dem mindestens ein Teil des Halbleitersubstratbereichs (4; 24; 44; 74; 104) durch Strukturierung mit Lochöffnungen oder Gräben versehen ist, deren Tiefe größer ist als ihr Durchmesser bzw. ihre Breite.

6. Integriertes Beschaltungsbauelement gemäß einem der vorhergehenden Ansprüche, bei dem die erste und die zweite Elektrode der Kondensatorstruktur (6; 26; 46; 76; 106) jeweils mit einem der Anschlüsse (12,14; 32,34; 52,56; 82,84,88; 112,118) zum Anschluss an das zu beschaltende elektrische Netzwerk verbunden ist.

7. Integriertes Beschaltungsbauelement gemäß einem der vorhergehenden Ansprüche, bei dem die Anschlüsse (12,14; 32,34; 52,56; 82,84,88; 112,118) zum Anschluss an das zu beschaltende elektrische Netzwerk sämtlich auf einer Seite des Beschaltungsbauelements liegen.

8. Integriertes Beschaltungsbauelement gemäß einem der Ansprüche 1 bis 6, bei dem die Anschlüsse (12,14; 32,34; 52,56; 82,84,88; 112,118) zum Anschluss an das zu beschaltende elektrische Netzwerk auf unterschiedlichen Seiten des Beschaltungsbauelements liegen.

9. Integriertes Beschaltungsbauelement gemäß Anspruch 3, bei dem ein elektrischer Widerstand der Widerstandstruktur (16; 36; 60; 92; 122) über eine spezifische Leitfähigkeit des Halbleitersubstratbereichs der ersten Elektrode (4; 24; 44; 74; 104) der Kondensatorstruktur und/oder weitere Halbleiterbereiche (2; 22; 42; 72; 102) des Halbleitersubstrats eingestellt ist.

10. Integriertes Beschaltungsbauelement gemäß Anspruch 3, bei dem ein elektrischer Widerstand der Widerstandstruktur (16; 36; 60; 92; 122) über eine Dotierung des Halbleitersubstratbereichs der ersten Elektrode (4; 24; 44; 74; 104) der Kondensatorstruktur eingestellt ist.

11. Integriertes Beschaltungsbauelement gemäß Anspruch 1, wobei das Beschaltungsbauelement mindestens eine Halbleiterstruktur mit nichtlinearer Strom-/Spannungskennlinie enthält (58; 90; 120).

12. Integriertes Beschaltungsbauelement nach Anspruch 1, wobei das Beschaltungsbauelement mindestens eine Transistorstruktur enthält.

13. Integriertes Beschaltungsbauelement nach Anspruch 1, wobei das Beschaltungsbauelement mindestens eine induktive Struktur enthält.

14. Integriertes Beschaltungsbauelement nach Anspruch 1 und 11 bis 12, wobei das Beschaltungsbauelement in einem Chip monolithisch integriert ist.

15. Integriertes Beschaltungsbauelement nach Anspruch 1, wobei die Widerstandstruktur (16; 36) und die Kondensatorstruktur (6; 26) derart in Serie geschaltet sind, dass ein erster Anschluss (14; 34) mit einem n-dotierten Halbleitersubstratbereich, der eine erste Elektrode (4; 24) der Kondensatorstruktur bildet, verbunden ist, wobei auf dem n-dotierten Halbleitersubstratbereich eine dielektrische Schicht (8; 28) angeordnet ist, die den Halbleitersubstratbereich (4; 24) konform bedeckt und auf der dielektrischen Schicht eine leitfähige Schicht (10; 30) angeordnet ist, die eine zweite Elektrode der Kondensatorstruktur bildet und mit einem zweiten Anschluss (12; 32) verbunden ist.

16. Verwendung eines integrierten Beschaltungsbauelements gemäß einem der vorhergehenden Ansprüche zur Beschaltung eines elektrischen Netzwerks zur Absorption von elektrischer Energie aus einem elektrischen Energiespeicher des elektrischen Netzwerks, um eine Schaltentlastung, Spannungsbegrenzung und/oder Schwingungsdämpfung des elektrischen Netzwerks zu erzielen.
